# EUROPEAN PATENT APPLICATION

(11) **EP 2 763 199 A1**
(43) Date of publication of application: **06.08.2014**
(21) Application number: 12835862.9
(22) Date of filing: 31.08.2012
(51) Int. Cl.: H01L 33/60

(54) **LIGHT-EMITTING ELEMENT MOUNTING SUBSTRATE AND LIGHT EMITTING DEVICE**

(30) Priority: 29.09.2011 JP 2011214808
(71) Applicant: Kyocera Corporation, Kyoto 612-8501 (JP)
(72) Inventor: TODA,Hajime, Kyoto-shi Kyoto 612-8501 (JP); NAKASUGA,Minoru, Kyoto-shi Kyoto 612-8501 (JP); NAKAMOTO,Tetsurou, Kyoto-shi Kyoto 612-8501 (JP); MIKAKI,Shunji, Kyoto-shi Kyoto 612-8501 (JP)
(74) Representative: Viering, Jentschura & Partner Patent- und Rechtsanwälte
(86) International application number: PCT/JP2012/072197
(87) International publication number: WO 2013/047087

(57) **Abstract**

[Problem] To provide a light-emitting element mounting substrate with a low volume resistivity rate which is not subject to destruction by electrostatic discharge, and a light emitting device constituted by mounting a light-emitting element on the light emitting element mounting substrate. [Solution] The light-emitting element mounting substrate is made of an alumina sintered compact, which contains 80 mass % or more of aluminum oxide given the total constituting component is 100 mass %, and the O / Al ratio, which is the ratio of atomic weight for O and Al in the crystal particle of the aluminum oxide, is less than 1.5, thus achieving the light-emitting element mounting substrate with low volume resistivity rate which is not subject to destruction by electrostatic discharge.

## Description

### TECHNICAL FIELD

The present invention relates to a light-emitting element mounting substrate and a light-emitting device constructed by mounting a light-emitting element on this light-emitting element mounting substrate.

### BACKGROUND ART

In recent years, LED (light-emitting diode) has been noted as a light-emitting element exhibiting high brightness and low power consumption and, then, is widely utilized as light sources of from general illumination to electric light display boards and backlights of cellular phones, personal computers, and the like.

In this regard, this light-emitting element is mounted on a conductor made from a metal disposed on a substrate. As for the substrate, ceramic having a high specific volume resistivity and good mechanical characteristics is used, and alumina-based sintered bodies are used frequently because production can be performed relatively inexpensively. For example, PTL 1 proposes highly reflective white ceramic composed of aluminum oxide and a glass-based component as such an alumina-based sintered body.

### CITATION LIST

### PATENT LITERATURE

PTL 1: Japanese Unexamined Patent Application Publication No. 2007-284333

### SUMMARY OF INVENTION

### TECHNICAL PROBLEM

The substrate made from the alumina-based sintered body, as described in PTL 1, is provided with a conductor on the surface and, therefore, is required to have a high specific volume resistivity. However, if the specific volume resistivity is too high, the substrate is easily charged with static electricity by contact or friction with the equipment or the like in the process of formation of the conductor, transport, or the like. Then, when a light-emitting element is mounted while the substrate is in the state of being charged with static electricity, the light-emitting element may be electrostatically damaged by discharge of the charged static electricity.

The present invention has been devised to solve the above-described problems, and it is an object to provide a light-emitting element mounting substrate having a low specific volume resistivity and a small possibility of electrostatic damage and a light-emitting device constructed by mounting a light-emitting element on this light-emitting element mounting substrate.

### SOLUTION TO PROBLEM

A light-emitting element mounting substrate according to the present invention is composed of an alumina-based sintered body in which aluminum oxide occupies 80 percent by mass or more thereof, where a total of constituent components is specified to be 100 percent by mass, and in which the O/Al ratio representing an atomic weight ratio of O to Al in crystal grains of the aluminum oxide is less than 1.5.

In addition, in a light-emitting device according to the present invention, a light-emitting element is mounted on the light-emitting element mounting substrate having the above-described configuration.

### ADVANTAGEOUS EFFECTS OF INVENTION

According to the light-emitting element mounting substrate of the present invention, the O/Al ratio representing the atomic weight ratio of O to Al in the crystal grains of the aluminum oxide is less than 1.5 and, therefore, the specific volume resistivity can be reduced and the possibility of charging of static electricity by contact or friction with the equipment or the like in the process of formation of the conductor, transport, or the like can be reduced.

Also, according to the light-emitting device of the present invention, a light-emitting device with high reliability can be constructed because a light-emitting element is mounted on the light-emitting element mounting substrate having a small possibility of electrostatic damage.

### BRIEF DESCRIPTION OF DRAWINGS

Fig. 1 is a partial sectional view showing an example of formation of a conductor on a light-emitting element mounting substrate according to the present embodiment.
Fig. 2 is a conceptual diagram showing a scattering state of diffuse reflection light of the light-emitting element mounting substrate according to the present embodiment.
Fig. 3 is a sectional view showing an example of the configuration of a light-emitting device constructed by mounting a light-emitting element on a light-emitting element mounting substrate according to the present embodiment.

### DESCRIPTION OF EMBODIMENTS

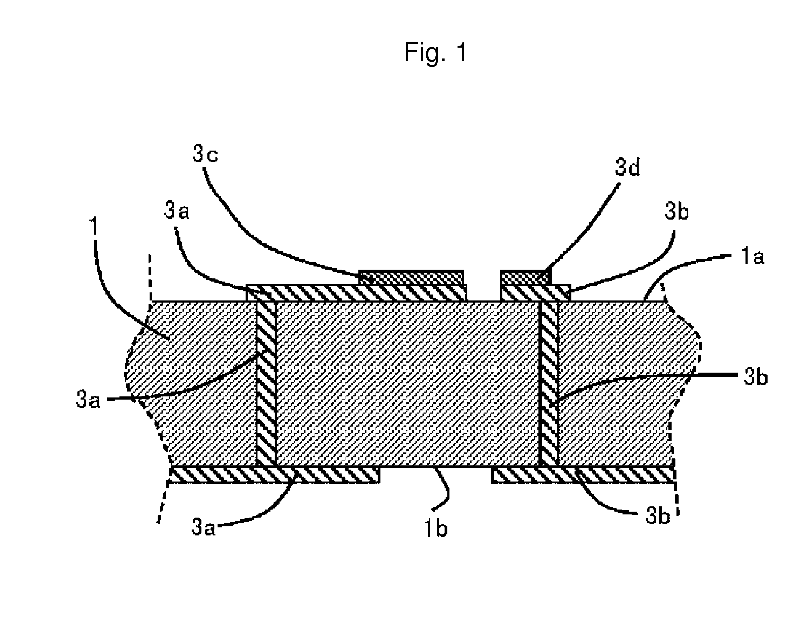

A light-emitting element mounting substrate according to the present embodiment and a light-emitting device in which a light-emitting element is mounted on this light-emitting element mounting substrate will be described below with reference to the drawings. Fig. 1 is a partial sectional view showing an example of formation of a conductor on the light-emitting element mounting substrate according to the present embodiment.

In an example shown in Fig. 1, electrodes 3a and 3b are disposed on one surface 1 a of a light-emitting element mounting substrate 1 (hereafter may be referred to as substrate 1), and electrode pads 3c and 3d are disposed on part of the electrodes 3a and 3b. A light-emitting element (not shown in the drawing) formed from a semiconductor is placed on the electrode pad 3c or the electrode pad 3d. In this regard, Fig. 1 shows the example in which electrodes 3a and 3b are also disposed in through holes and on the other surface 1 b.

Then, the light-emitting element mounting substrate 1 according to the present embodiment is made from an alumina-based sintered body in which the proportion of aluminum oxide is 80 percent by mass or more, where the total of constituent components is specified to be 100 percent by mass, and in which the O/Al ratio representing the atomic weight ratio of O to Al in the crystal grains of the aluminum oxide is less than 1.5. In this regard, in the following description, the O/Al ratio representing the atomic weight ratio of O to Al in the crystal grains of the aluminum oxide may be referred to as the O/Al ratio in the crystal grains of the aluminum oxide or the O/Al ratio simply. Here, the alumina-based sintered body contains, for example, at least one type of silicon oxide, magnesium oxide, and calcium oxide besides aluminum oxide constituting 80 percent by mass or more and is constructed by sintering while they are used as sintering aids.

Meanwhile, aluminum oxide is represented by a chemical formula Al₂O₃, and the O/Al ratio is 1.5 on a stoichiometric composition basis. On the other hand, in the present embodiment, the O/Al ratio is less than 1.5 and, therefore, the specific volume resistivity of the substrate 1 can be reduced, so that the possibility of charging of static electricity of the substrate 1 by contact or friction with the equipment or the like in the process of formation of the conductor, transport, or the like can be reduced.

Here, the term "the specific volume resistivity can be reduced" refers to that the specific volume resistivity of an alumina-based sintered body having an O/Al ratio of less than 1.5 shows a value lower than the specific volume resistivity (for example, 10¹⁴ Ω·cm) of an alumina-based sintered body having an O/Al ratio of 1.5, where the sintering aid components and contents in the sintered bodies are the same and the remainder is composed of aluminum oxide. The specific volume resistivity can be measured in conformity with JIS C 2141-1992. In this regard, the reasons the specific volume resistivity can be reduced are considered to be an influence of O (oxygen) coming out of Al₂O₃ and an influence of excess Al (aluminum), although details are not certain.

Also, the O/Al ratio in the crystal grains of the aluminum oxide of the light-emitting element mounting substrate 1 according to the present embodiment is preferably 0.7 or more and 1.3 or less. In the case where this O/Al ratio is 0.7 or more and 1.3 or less, the light-emitting element mounting substrate 1 can have high reflectance in addition to a low specific volume resistivity.

Here, the O/Al ratio in the crystal grains of the aluminum oxide is calculated by the following method. Initially, as for pretreatment, a cross-section of the substrate 1 is mirror-finished, is treated with an ion milling system (MODEL 691 produced by GATAN), and is observed with a transmission electron microscope (TEM, for example, JEM-2010F produced by JEOL LTD.) at a magnification of 40,000 times to 60,000 times, where arbitrary 10 crystal grains of aluminum oxide are selected. Subsequently, atomic weights of O and Al are measured by an attached energy dispersive X-ray analysis (EDS, for example, NSS produced by Thermo Electron), where a spot diameter is 1 nm, a measurement time is 50 seconds, a measurement energy width is 0.14 to 20.48 keV, and a semiquantitative calculation method is a thin-film approximation method, and the O/Al ratios of the individual crystal grains of aluminum oxide are calculated from the resulting atomic weights. An average value of them is specified to be the O/Al ratio of the crystal grains of aluminum oxide.

Meanwhile, in the case where the O/Al ratio in the crystal grains of the aluminum oxide of the light-emitting element mounting substrate 1 according to the present embodiment is 0.7 or more and 1.3 or less, there is a method in which evaluation is performed on the basis of the incident angle (2θ) causing appearance of a peak of the 104 face resulting from α-aluminum oxide in X-ray diffraction (CuKα line). This can be ascertained by the value of 2θ because according to JCPDS card (#46-1212) of α-aluminum oxide, the peak of the 104 face appears at 2θ = 35.152°, but in the case where the O/Al ratio in the crystal grains of the aluminum oxide of the light-emitting element mounting substrate 1 according to the present embodiment is less than 1.5, the peak of the 104 face shifts to the larger angle side (incident angle is large). Specifically, when the O/Al ratio is 0.7 or more and 1.3 or less, the peak appears in the range of 35.20° or more and 35.35° or less on a numerical value of 2θ basis.

Meanwhile, in order to reduce the possibility of electrostatic damage of the light-emitting element and, in addition, suppress short circuit between electrodes or wirings in the case where an irregular voltage occurs in the substrate 1 because of an influence of lightning strike and a malfunction of a wiring circuit breaker or the like, the specific volume resistivity is preferably 10⁹ to 10¹² Ω·cm.

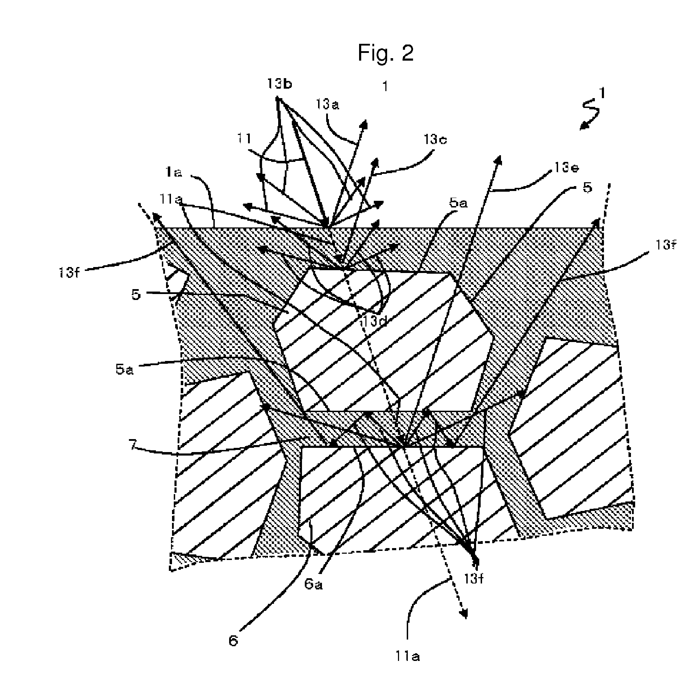

Fig. 2 is a conceptual diagram showing a scattering state of diffuse reflection light of the light-emitting element mounting substrate 1 according to the present embodiment. In this regard, this conceptual diagram shows a cross-section perpendicular to the surface 1 a and, as shown in Fig. 2, when the light-emitting element mounting substrate 1 according to the present embodiment is viewed at a crystal size level, crystal grains 5 and 6 of aluminum oxide and a grain boundary phase 7 primarily composed of a sintering aid component are included. In this regard, in the case where the grain boundary phase 7 is at least one type of silicon oxide, magnesium oxide, and calcium oxide, the grain boundary phase 7 is present as an amorphous glass phase.

Then, incident light 11 applied from the surface 1 a side of the light-emitting element mounting substrate 1 according to the present embodiment becomes regular reflection light 13a reflected in a specific direction from the surface 1a and diffuse reflection light 13b reflected in indefinite directions from the surface 1 a, and the remainder light becomes light 11a which advances (pass through) in the inside of the substrate 1. Furthermore, this light 11a which advances in the inside of the substrate 1 becomes regular reflection light 13c and diffuse reflection light 13d at the interface 5a, that is a border with the grain boundary phase 7, of the crystal grain 5 of aluminum oxide, and the remainder becomes light 11a which further advances in the inside of the substrate 1.

Then, this light 11a which further advances in the inside of the substrate 1 becomes regular reflection light 13e and diffuse reflection light 13f at the interface 6a, that is a border with the grain boundary phase 7, of the crystal grain 6 of aluminum oxide, and the remainder becomes light 11a which further advances in the inside of the substrate 1. In this regard, the regular reflection lights 13a, 13c, and 13d and the diffuse reflection lights 13b, 13d, and 13f go out of the substrate 1 when no collision with a crystal grain occurs, or go out of the substrate 1 after repetition of regular reflection and diffuse reflection at interfaces or passing through a crystal grain when collision with a crystal grain occurs.

In addition, an average grain size of crystal grains of aluminum oxide of light-emitting element mounting substrate 1 according to the present embodiment is preferably 0.7 µm or more and 2.0 µm or less. In the case where the average grain size of crystal grains of aluminum oxide is 0.7 µm or more and 2.0 µm or less, the light-emitting element mounting substrate 1 can have high reflectance while having a low specific volume resistivity. This is because the grain boundary phase 7 composed of an amorphous glass phase having a high specific volume resistivity is not excessive and interfaces which reflect light can increase.

Here, as for the method for determining the average grain size of the crystal grains of aluminum oxide, initially, a cross-section of the substrate 1 is mirror-finished, and fire-etching is performed at a temperature 50°C to 100°C lower than the maximum temperature in a firing step of the substrate 1. Subsequently, photographing is performed with a scanning electron microscope (SEM, for example, JSM-7001 F produced by JEOL LTD.) at a magnification of 1,000 to 3,000 times, the photographed image is analyzed with an image analyzer (for example, Win ROOF produced by MITANI CORPORATION) and, thereby, areas of the individual crystal grains of aluminum oxide are determined. The diameters of circles having the same areas as these areas (equivalent circle diameters) may be calculated, and an average of the equivalent circle diameters may be calculated.

Also, the light reflectance of the light-emitting element mounting substrate 1 according to the present embodiment is measured with a spectrophotometer (for example, UV-315: produced by SHIMADZU CORPORATION and ISR-3100: accessory integrating sphere unit) by using 50 W halogen lamp and deuterium lamp as light sources without using a mask, where the wavelength range is specified to be 200 to 1,000 nm, the measurement range is specified to be 7 × 9 mm, and the slit width is specified to be 20 nm. In this regard, here, the reflectance refers to a relative value, where the reflectance of a barium sulfate powder used as a reference is specified to be 100%.

Meanwhile, it is preferable that no transition metal is contained in a grain boundary phase of the light-emitting element mounting substrate 1 according to the present embodiment. In the case where no transition metal is contained in the grain boundary phase, as described above, reduction in reflectance due to darkening of the substrate 1 can be suppressed and, thereby, it is possible to use for mounting of a light-emitting element favorably. In this regard, in the present embodiment, as for whether the grain boundary phase contains a transition metal or not, the spot to be applied may be switched from a crystal grain to a grain boundary phase in the same measuring method as that for determining the above-described O/Al ratio.

Then, in the case where the component other than incidental impurities contained in the light-emitting element mounting substrate 1 according to the present embodiment is at least one type of silicon oxide, calcium oxide, and magnesium oxide, which is a sintering aid component, the proportion of aluminum oxide is 94 percent by mass or more, where the total of constituent components is specified to be 100 percent by mass. When the proportion of aluminum oxide is 94 percent by mass or more, as described above, a glass phase on the basis of the sintering aid constituting the grain boundary phase 7 increases excessively and, thereby, reduction in reflectance due to passing through of the incident light 11 to the back surface can be suppressed, so that the reflectance of the incident light 11 can be maintained at a high level.

Meanwhile, in the case where barium oxide is contained to increase the reflectance, the remainder excluding this barium oxide, sintering aid components, and incidental impurities may be aluminum oxide.

In this regard, the contents of the individual components of the light-emitting element mounting substrate 1 according to the present embodiment may be determined by determining the amounts of metal elements with an ICP (Inductively Coupled Plasma) emission spectrochemical analyzer or fluorescent X-ray analyzer and, thereafter, converting them to the respective oxides. Also, aluminum oxide may be determined by subtracting the contents of the other components in terms of oxide from 100 percent by mass. Aluminum oxide in the present embodiment constitutes 80 percent by mass or more on the basis of this calculation method.

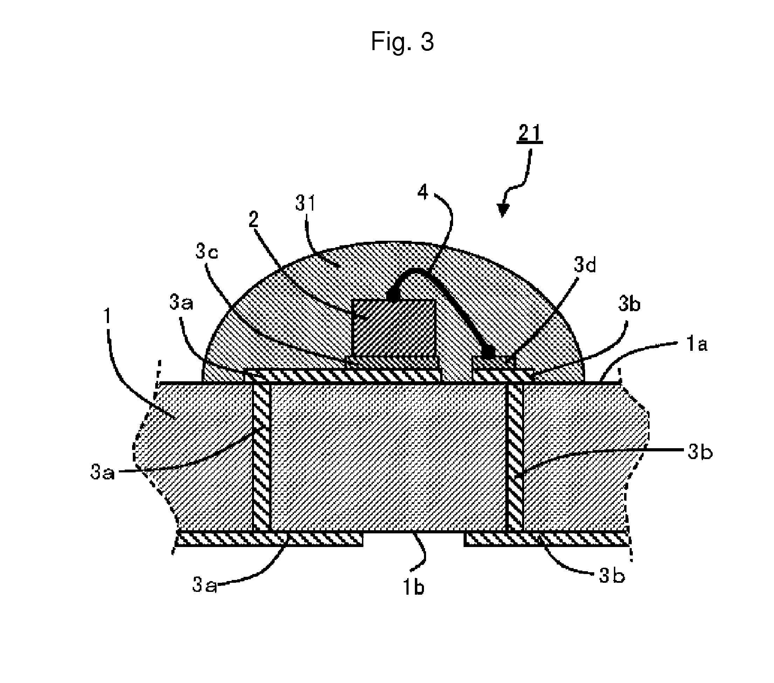

Fig. 3 is a sectional view showing an example of the configuration of a light-emitting device constructed by mounting a light-emitting element on the light-emitting element mounting substrate according to the present embodiment. As described above, a light-emitting device 21 according to the present embodiment is constructed by mounting a light-emitting element 2 on the light-emitting element mounting substrate 1 according to the present embodiment.

In the light-emitting device 21 shown in Fig. 3, electrodes 3a and 3b and, furthermore, electrode pads 3c and 3d are disposed on the surface 1 a of the substrate 1, the light-emitting element 2 formed from a semiconductor is mounted on the electrode pad 3a, and the light-emitting element 2 and the electrode pad 3d are electrically connected by a bonding wire 4. In this regard, the light-emitting element 2 may be mounted by bonding with an electrically conductive adhesive, bonding with a bonding wire, or bonding with a solder bump with no problem insofar as electrical bonding is possible.

In addition, the light-emitting element 2, the electrodes 3a and 3b, electrode pads 3c and 3d, and the bonding wire 4 are covered by a sealing member 31 formed from a resin or the like. In this regard, the electrodes 3a and 3b and the electrode pads 3c and 3d are protected by a transparent overcoat glass, and the sealing member 31 has functions of protection of the light-emitting element 2 and a lens in combination. Also, the configuration of the light-emitting device 21 according to the present embodiment is not limited to the configuration shown in Fig. 3 insofar as the light-emitting element 2 is mounted on the substrate 1 according to the present embodiment.

Meanwhile, connection to an external direct-current power supply (not shown in the drawing) or an AC-DC switching power supply (not shown in the drawing) is performed, the power is turned on between the electrodes 3a and 3b on the other surface of the substrate 1 (back electrodes) and, thereby, the light-emitting element 2 emits light. At this time, the sealing member 31 protects the light-emitting element 2 and has a function as a lens to diffuse and radiate light, although the sealing member 31 may have a function to convert the wavelength of light selectively.

Then, the light-emitting device 21 according to the present embodiment has a small possibility of electrostatic damage to the light-emitting element 2 in mounting because the light-emitting element mounting substrate 1 according to the present embodiment to be mounted with the light-emitting element 2 has a low specific volume resistivity and a small possibility of charging of static electricity by contact or friction with the equipment or the like in the process of formation of the conductor, transport, or the like, so that the light-emitting device 21 can exhibit high reliability.

Next, an example of a method for manufacturing the light-emitting element mounting substrate 1 according to the present embodiment will be described. Initially, an aluminum oxide (Al₂O₃) powder having an average particle diameter of 0.5 to 1.8 µm and a powder of at least one type of silicon oxide, calcium oxide (CaO), and magnesium oxide (MgO) serving as a sintering aid are prepared. Thereafter, a starting material is prepared by performing weighing in such a way that the sintering aid becomes 6 percent by mass or less in total and the remainder becomes aluminum oxide, where the total of aluminum oxide and the sintering aid is specified to be 100 percent by mass.

Then, the weighed starting material is put into a mill or the like holding high purity alumina balls and is pulverized and mixed together with a solvent, e.g., water. Subsequently, about 4 to 8 parts by mass of forming binder composed of at least one type of paraffin wax, polyvinyl alcohol, polyethylene glycol, butyral resin, and acrylic resin (carbon is contained in these forming binders) is added relative to 100 parts by mass of starting material, and a slurry is obtained by further rotating the mill to perform mixing.

Thereafter, a sheet is formed by a doctor blade method using the resulting slurry or a sheet is formed by a known powder press forming method or roll compaction method using granules produced through spray granulation of the resulting slurry with a spray dryer. Then, a compact is obtained by treating the sheet by a die or laser to make into a product shape. At this time, multiple production of compacts is preferable from the viewpoint of the mass productivity of the substrate 1.

Subsequently, the resulting compact is subjected to degreasing in an air (oxidizing) atmosphere and is fired in a firing furnace (for example, a batch type controlled atmosphere electric furnace using a tungsten heater) which can be adjusted to have an inert gas atmosphere (inert gas is argon or the like) or an atmosphere with an oxygen concentration of 5 to 20 percent by volume at a maximum temperature within the range of 1,420°C to 1,650°C.

Meanwhile, the O/Al ratio can be adjusted by the firing atmosphere, and the average grain size of crystal grains of aluminum oxide can be adjusted by the size of the starting material and the firing condition.

The examples according to the present invention will be specifically described below, although the present invention is not limited to the following examples.

### EXAMPLE 1

To begin with, a change in the specific volume resistivity due to a difference in the O/Al ratio was evaluated.

An aluminum oxide (Al₂O₃) powder having an average particle diameter of 1.8 µm and powders of silicon oxide (SiO₂), calcium oxide (CaO), and magnesium oxide (MgO) serving as sintering aids were prepared. Thereafter, 94 percent by mass of aluminum oxide, 3.5 percent by mass of silicon oxide, 1.5 percent by mass of calcium oxide, and 1.0 percent by mass of magnesium oxide were weighed and this was used as a starting material. A forming binder composed of a solvent and an acrylic resin was added thereto, and a slurry was obtained by performing mixing. Here, the amount of addition of the forming binder was specified to be 6 parts by mass relative to 100 parts by mass of the starting material.

Thereafter, a sheet was formed by a known doctor blade method using the resulting slurry, and the resulting sheet was stamped with a die, so that two compacts were obtained. Then, initially, one compact was put into an electric furnace, and firing was performed at a maximum temperature of 1,500°C while the atmosphere was adjusted to have an oxygen concentration of 16 percent by volume, so that a light-emitting element mounting substrate of Sample No. 1 having a thickness of 0.6 mm was obtained. Meanwhile, the other compact was fired while the firing atmosphere was specified to be an air atmosphere, so that a light-emitting element mounting substrate of Sample No. 2 was obtained.

Subsequently, the O/Al ratio of the resulting light-emitting element mounting substrate was measured with TEM-EDS by the following method.

A cross-section of each sample was mirror-finished, was treated with an ion milling system, and was observed with TEM at a magnification of 50,000 times, where arbitrary 10 crystal grains of aluminum oxide were selected. Subsequently, atomic weights of O and Al were measured by attached EDS, where a spot diameter was 1 nm, a measurement time was 50 seconds, a measurement energy width was 0.14 to 20.48 keV, and a semiquantitative calculation method was a thin-film approximation method, and the O/Al ratios of the individual crystal grains of aluminum oxide were calculated from the resulting atomic weights. An average value of them was further calculated.

Next, the specific volume resistivity was measured referring to the measurement of specific volume resistivity described in JIS C 2141-1992.

As a result, Sample No. 1 had an O/Al ratio of 0.92 and a specific volume resistivity of 5 × 10¹¹ Ω·cm, and Sample No. 2 had an O/Al ratio of 1.5 and a specific volume resistivity of 1 × 10¹⁴ Ω·cm. As is clear from these results, the specific volume resistivity was able to be reduced by specifying the O/Al ratio to be less than 1.5.

### EXAMPLE 2

Next, changes in the specific volume resistivity and the reflectance due to the O/Al ratio were evaluated.

Initially, compacts were produced in the same steps as those in Example 1. Thereafter, each compact was fired in an electric furnace while the atmosphere was adjusted to have an oxygen concentration within the range of 5 to 20 percent by volume in accordance with the sample. In this regard, firing was performed at a maximum temperature of 1,500°C, so that light-emitting element mounting substrates of Sample Nos. 3 to 9 were obtained.

Subsequently, the resulting light-emitting element mounting substrates were subjected to calculation of the O/Al ratio and measurement of the specific volume resistivity in the same methods as those in Example 1. The reflectance was measured with a spectrophotometer by using 50 W halogen lamp and deuterium lamp as light sources without using a mask, where the wavelength range was specified to be 500 nm, the measurement range was specified to be 7 × 9 mm, and the slit width was specified to be 20 nm. In this regard, a barium sulfate powder was used as a reference.

Meanwhile, as for overall evaluation of each sample, a sample exhibited a reflectance of 91 % or more at a wavelength of 500 nm and, in addition, a specific volume resistivity of less than 1 × 10¹³ Ω·cm was "excellent" and expressed as A. In the case where any one of a reflectance of 91 % or more and a specific volume resistivity of less than 1 × 10¹³ Ω·cm was not satisfied, the sample was "good" and was expressed as B. The results are shown in Table 1.

**[Table 1]**

| Sample No. | O/Al ratio | Specific volume resistivity (Ω·cm) | Reflectance (%) | Overall evaluation |
|---|---|---|---|---|
| 3 | 1.40 | 2 × 10¹³ | 93.1 | B |
| 4 | 1.30 | 4 × 10¹² | 92.8 | A |
| 5 | 1.24 | 2 × 10¹² | 92.0 | A |
| 6 | 0.88 | 5 × 10¹⁰ | 91.5 | A |
| 7 | 0.70 | 1 × 10⁹ | 91.0 | A |
| 8 | 0.66 | 7 × 10⁸ | 90.4 | B |
| 9 | 0.57 | 4 × 10⁸ | 86.8 | B |

As is clear from the results shown in Table 1, Sample Nos. 4 to 7 exhibited O/Al ratios of 0.7 or more and 1.3 or less and, therefore, the reflectances were 91 % or more and the specific volume resistivities were less than 1 × 10¹³ Ω·cm, so that the light-emitting element mounting substrates had low specific volume resistivities and, in addition, high reflectances.

### EXAMPLE 3

Next, changes in the specific volume resistivity and the reflectance due to a difference in the average grain size of crystal grains of aluminum oxide were evaluated.

Initially, compacts were produced in the same steps as those in Example 1. Thereafter, firing was performed in an electric furnace in an atmosphere having an oxygen concentration of 12 percent by volume while the maximum temperature in the firing was adjusted to be 1,450°C to 1,550°C in accordance with the sample. In this manner, light-emitting element mounting substrates of Sample Nos. 10 to 16 were obtained.

Subsequently, the specific volume resistivity was measured in the same methods as that in Example 1, and the reflectance was measured in the same manner as that in Example 2. Then, the average grain size was determined by the following method.

Initially, a cross-section of each sample was mirror-finished, and fire-etching was performed at a temperature 80°C lower than the maximum temperature in the firing step of each sample. Thereafter, photographing was performed with the SEM at a magnification of 2,500 times, the photographed image was analyzed with an image analyzer and, thereby, areas of the individual crystal grains of aluminum oxide were determined. The diameters of circles having the same areas as these areas (equivalent circle diameters) were calculated, and the average of the equivalent circle diameters was calculated. The results are shown in Table 2.

**[Table 2]**

| Sample No. | Average grain size (µm) | Specific volume resistivity (Ω·cm) | Reflectance (%) |
|---|---|---|---|
| 10 | 2.8 | 5 × 10¹⁰ | 90.5 |
| 11 | 2.5 | 1 × 10¹⁰ | 91.3 |
| 12 | 2.0 | 8 × 10⁹ | 92.5 |
| 13 | 1.4 | 5 × 10⁹ | 92.9 |
| 14 | 1.0 | 4 × 10⁹ | 93.0 |
| 15 | 0.7 | 2 × 10⁹ | 92.4 |
| 16 | 0.5 | 2 × 10¹⁰ | 91.8 |

As is clear from Table 2, the results of the reflectances of Sample Nos. 12 to 15 were high 92% or more, the average grain sizes of crystal grains of aluminum oxide were 0.7 µm or more and 2.0 µm or less and, therefore, the light-emitting element mounting substrates were able to have high reflectances in addition to low specific volume resistivities.

### EXAMPLE 4

Next, an influence of presence or absence of a transition metal in the grain boundary phase on the reflectance was evaluated.

A powder A and a powder B were prepared as two types of aluminum oxide powders. Thereafter, sintered bodies were obtained in the same steps as those of Sample No. 6 in Example 2 except that these powders A and B were used. Subsequently, the sintered body produced by using the powder A was specified to be Sample No. 17, and the sintered body produced by using the powder B was specified to be Sample No. 18.

Then, qualitative analysis of the grain boundary phase was performed, where the spot to be applied in the O/Al ratio measurement with TEM-EDS in Example 1 was switched from a crystal grain to a grain boundary phase. Meanwhile, the reflectance was measured in the same manner as that in Example 2.

As a result, O, Al, Si, Ca, and Mg were detected in the grain boundary phases of both of Sample Nos. 17 and 18, and Fe was detected in only Sample No. 17. Also, the reflectance of Sample No. 17 was 90.8%, and the reflectance of Sample No. 18 was 91.8%. As is clear from this result, it is preferable that the substrate used for mounting of a light-emitting element do not contain a transition metal in a grain boundary phase.

### EXAMPLE 5

Next, an influence of electrostatic damage in mounting of the light-emitting element 2 on the light-emitting element mounting substrate 1 was evaluated.

Initially, light-emitting devices were produced by using Sample Nos. 1 and 2 produced in Example 1, forming the electrode 3a, electrode pad 3c, and the like, and mounting the light-emitting element 2. Subsequently, in the present example, presence or absence of light emission of the element was assumed to be an influence of electrostatic damage, and 200 units per sample were examined. As a result, the number of elements which did not emit light in the light-emitting devices constructed by mounting the light-emitting element on Sample No. 2 was clearly smaller than that in the light-emitting devices constructed by mounting the light-emitting element on Sample No. 1. As is clear from this, the possibility of charging of static electricity by contact or friction with the equipment or the like in the process of formation of the conductor, transport, or the like was able to be reduced because the specific volume resistivity of the light-emitting element mounting substrate 1 was low and, therefore, a light-emitting device was able to exhibit high reliability because the possibility of electrostatic damage of the light-emitting element 2 in mounting was able to be reduced by using such a light-emitting element mounting substrate 1.

### REFERENCE SIGNS LIST

1: light-emitting element mounting substrate (substrate)
1 a: surface
1 b: the other surface
2: light-emitting element
3: conductor
3a, 3b: electrode
3c, 3d: electrode pad
4: bonding wire
5, 6: crystal grains of aluminum oxide
5a, 6a: interfaces
7: grain boundary phase (glass layer)
11: incident light
11a: light which advances in the inside
13: reflected light
13a, 13c, 13e: regular reflection light
13b, 13d, 13f: diffuse reflection light
21: light-emitting device
31: sealing member

## Claims

1. A light-emitting element mounting substrate composed of an alumina-based sintered body in which aluminum oxide occupies 80 percent by mass or more thereof, where a total of constituent components is specified to be 100 percent by mass, and in which an O/Al ratio representing an atomic weight ratio of O to Al in crystal grains of the aluminum oxide is less than 1.5.

2. The light-emitting element mounting substrate according to claim 1, wherein the O/Al ratio is 0.7 or more and 1.3 or less.

3. The light-emitting element mounting substrate according to claim 1 or 2, wherein an average grain size of the crystal grains of the aluminum oxide is 0.7 µm or more and 2.0 µm or less.

4. The light-emitting element mounting substrate according to any one of claims 1 to 3, wherein no transition metal is contained in a grain boundary phase.

5. A light-emitting device in which a light-emitting element is mounted on the light-emitting element mounting substrate according to any one of claims 1 to 4.
